# EUROPEAN PATENT APPLICATION

(11) **EP 1 978 137 A1**
(43) Date of publication of application: **08.10.2008**
(21) Application number: 07707356.7
(22) Date of filing: 18.01.2007
(51) Int. Cl.: C30B 29/36, C30B 19/04

(54) **PROCESS FOR PRODUCING SiC SINGLE CRYSTAL**

(30) Priority: 24.01.2006 JP 2006014726
(71) Applicant: Toyota Jidosha Kabushiki Kaisha, Toyota-shi, Aichi 471-8571 (JP)
(72) Inventor: SAKAMOTO, Hidemitsu, Toyota-shi, Aichi 471-8571 (JP)
(74) Representative: Duckworth, Timothy John
(86) International application number: PCT/JP2007/051109
(87) International publication number: WO 2007/094155

(57) **Abstract**

A method of production of SiC single crystal using the solution method able to stably maintain flatness of a growth surface, prevent polycrystallization, and grow a large sized SiC single crystal is provided. A method of growing a hexagonal SiC single crystal starting from a hexagonal SiC seed crystal held directly under a melt surface of an Si melt in a graphite crucible by maintaining in the Si melt a temperature gradient such that the temperature falls from the inside toward the melt surface of the Si melt, **characterized by**:
growing said SiC single crystal on a surface of said SiC seed crystal, which surface is inclined at a selected off angle from a (0001) plane of the SiC seed crystal in a [1-100] direction of the SiC seed crystal. The off angle is preferably 1 to 30°, while growing the SiC single crystal on the (1-100) surface where the off angle is 90° is most preferable.

## Description

### TECHNICAL FIELD

The present invention relates to a method of production of an SiC single crystal by the solution method.

### BACKGROUND ART

SiC semiconductors have larger energy band gaps compared with Si semiconductors and are superior in withstand voltage characteristics, operating temperature, and heat resistance, so offer great promise for application to power devices and environmentally resistant devices. As crystal systems of SiC, there are hexagonal and cubic systems etc. In particular, as semiconductor materials, the 6H type (hexagonal having six molecules as one unit cell), the 4H type (hexagonal having four molecules as one unit cell) are considered promising. Various techniques for production of high quality SiC single crystal suitable for semiconductor materials have been proposed.

As methods of production of SiC single crystal, mainly the sublimation method and the solution method are known. The sublimation method is the method most generally used as the method of production of SiC single crystal and causes sublimation of SiC material powder to cause precipitation on a low temperature SiC seed crystal. Among the crystal planes of an SiC seed crystal, as the growth plane of the SiC single crystal, the hexagonal (0001) plane (=basal plane) or (11-20) plane is used. If growing the crystal on the (0001) plane, screw dislocation occurs in the growth direction, i.e. the C-axial direction, and micropipes undesirably occur. If growing the crystal on the (11-20) plane, stacking faults occur.

Regarding the sublimation method, Japanese Patent Publication (A) No. 07-267795 proposes the method using as a growth surface the surface of the SiC seed crystal inclined from the (0001) plane in the [000-1] direction, Japanese Patent Publication (A) No. 10-017399 proposes a method using as a growth surface the (11-20) plane of the SiC seed crystal, and Japanese Patent Publication (A) No. 2003-300797 proposes a method using a growth surface a surface of the SiC seed crystal with an off angle to the (11-20) surface. These are intended to suppress the occurrence of micropipes or stacking faults, but sufficiently high quality as a semiconductor material is not achieved.

On the other hand, the solution method is the method of making C dissolve in the Si melt from a graphite crucible and growing SiC single crystal on an SiC seed crystal arranged at the melt surface. The micropipes and stacking faults unavoidable in the sublimation method do not occur, so this is suitable for obtaining the high quality SiC single crystal necessary for a semiconductor material, but there was the problem that it was difficult to stably maintain a flat crystal growth surface.

That is, the solution method is a thermally equilibrium process. In this respect, control of the growth conditions should be easier than with the sublimation method. However, to stably maintain a flat crystal growth surface, control of the convection of the solvent, control of the temperature gradient, etc. must be performed extremely delicately.

However, control tracking environmental conditions changing from one instant to another is practically impossible. For example, if a crystal nucleus is formed at part of the surface of the seed crystal, this will form the base point for a chain formation of nuclei, polycrystallization (polynucleation and facet formation) will undesirably progress, and as a result the problem will arise of the growth being not flat 2D growth, but 3D growth and an extremely rough growth surface will be formed. Moreover, if polycrystallization occurs in the above way (polynucleation and facet formation), growth in the diametrical direction will also be inhibited, so there was also the problem that large diameter SiC single crystal could not be obtained with a good yield.

As a measure against this, Japanese Patent Publication (A) No. 06-227886 proposes to use the sublimation method or the solution method to grow SiC single crystal by using a seed crystal having a side surface, with respect to the growth surface of the seed crystal, inclined from both of the (0001) plane and (1-100) plane. However, in this method as well, it was not possible to reliably prevent polycrystallization (polynucleation and faceting) and was not possible to stably produce a large diameter SiC single crystal with a high growth surface flatness.

### DISCLOSURE OF THE INVENTION

The present invention has as its object the provision of a method of production of SiC single crystal using the solution method able to stably maintain flatness of a growth surface, prevent polycrystallization, and grow a large diameter SiC single crystal.

To achieve the above object, according to the present invention, there is provided a method of growing a hexagonal SiC single crystal starting from a hexagonal SiC seed crystal held directly under a melt surface of an Si melt in a graphite crucible by maintaining in the Si melt a temperature gradient such that the temperature falls from the inside toward the melt surface of the Si melt, characterized by:
growing said SiC single crystal on a surface of said SiC seed crystal, which surface is inclined at a selected off angle from a (0001) plane of the SiC seed crystal in a [1-100] direction of the SiC seed crystal.

In the present invention, by growing the SiC single crystal on a surface of an SiC seed crystal inclined from a (0001) surface in the [1-100] direction by a predetermined off angle, it is possible to stably maintain flatness of a growth surface, prevent polycrystallization, and grow a large diameter SiC single crystal.

### BRIEF DESCRIPTION OF THE DRAWINGS

FIG. 1 is a perspective view showing the crystal growth surface of a seed crystal used for the method of production of SiC single crystal of the present invention.
FIG. 2 is a perspective view showing the crystal growth surface of a seed crystal used in the conventional sublimation method.
FIG. 3 is a vertical cross-sectional view showing an example of the structure of an SiC single crystal production furnace suitable for working the method of production of a SiC single crystal of the present invention.
FIG. 4 is a photograph of the cross-section including the growth axis from a graphite rod through a seed crystal to a single crystal growth layer when inclining the growth surface from the (0001) plane in the [1-100] direction by an off angle θ=4° to grow an SiC single crystal according to the present invention.
FIG. 5 is (1) a photograph of the cross-section including the growth axis from a graphite rod through a seed crystal to a single crystal growth layer and (2) a sketch of the contour of the growth surface when making the growth surface the (1-100) surface (that is, an off angle 0=90° from the (0001) surface in the [1-100] direction) to grow an SiC single crystal according to the present invention.
FIG. 6 is a photograph of the cross-section including the growth axis from a graphite rod through a seed crystal to a single crystal growth layer when using as the growth surface the (0001) surface for growing an SiC single crystal for comparison.
FIG. 7 is a photograph of a growth surface when inclining the growth surface from the (0001) surface in the [11-20] direction by an off angle of 8° to grow an SiC single crystal for comparison.
FIG. 8 is (1) a photograph of the cross-section including the growth axis from a graphite rod through a seed crystal to a single crystal growth layer and (2) a photograph of the growth surface of an SiC single crystal when using as the growth surface the (11-20) surface (that is, an off angle θ=90° from the (0001) surface in the [11-20] direction) to grow an SiC single crystal for comparison.

### BEST MODE FOR CARRYING OUT THE INVENTION

The inventors newly discovered the fact that if growing an SiC single crystal using as the growth surface a surface of a hexagonal SiC seed crystal inclined from the (0001) surface in the [1-100] direction by a predetermined off angle, the growth surface is stably maintained flat, growth in the diametrical direction is promoted without polycrystallization (polynucleation and faceting), and a large diameter SiC single crystal can be obtained with a high yield and completed the present invention based on the fact.

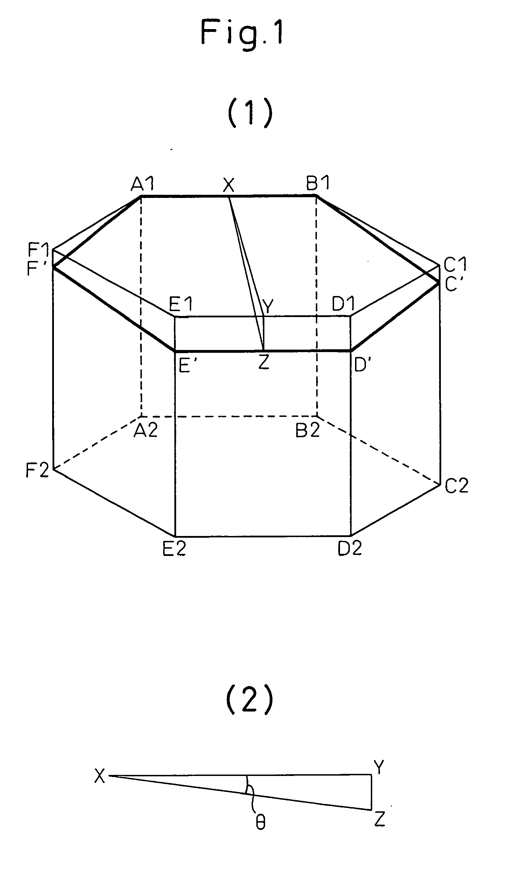

As shown in FIG. 1, the (0001) plane of a hexagonal SiC seed crystal is the basal plane of a regular hexagon, that is, the (A1-B1-C1-D1-E1-F1) plane. Another basal plane of the regular hexagonal column illustrated (A2-B2-C2-D2-E2-F2) is an equivalent (0001) plane. Further, the six rectangular side surfaces of a regular hexagonal column (E1-D1-D2-E2 etc.) are the (1-100) plane and equivalent planes to this.

The growth surface used in the present invention is the surface inclined from the (0001) basal plane (=(A1-B1-C1-D1-E1-F1) plane) toward the (1-100) plane (=side surface (E1-D1-D2-E2)), i.e. in the [1-100] direction, by an off angle θ (see FIG. 1(2)) (=(A1-B1-C'-D'-E'-F') plane).

In general, a SiC single crystal (0001) plane is used for fabrication of semiconductor devices. In the production of an SiC single crystal as well, the (0001) plane is generally used as the basic growth surface.

In the present invention, as the growth surface, not the (0001) plane as it is, but a plane inclined from the (0001) plane in the [1-100] direction is used. Due to this, polycrystallization (polynucleation and faceting) is prevented, a high flatness of the crystal growth surface is maintained, and growth in the diametrical direction proceeds well for easily realization of a larger diameter.

If making the angle of inclination from the (0001) plane in the [1-100] direction (off angle θ) 1 to 30°, the flattening of the growth surface is the best.

Furthermore, if making the off angle θ 90° and making the growth surface the (1-100) surface (=(E1-D1-D2-E2) surface etc.), the best flat growth is obtained. In this case, the ratio of size enlargement (ratio of growth in diametrical direction with respect to seed crystal) is particularly large. This direction is best suited to enlargement of size.

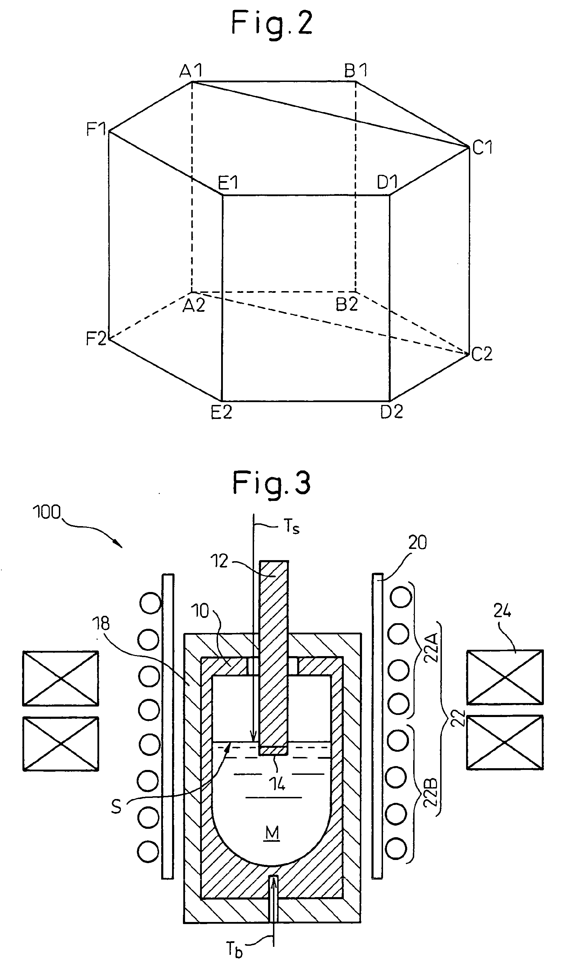

In epitaxial growth by the CVD method etc. among conventional vapor phase growth methods, the (11-20) plane ((A1-C1-C2-A2) plane of FIG. 2 etc.) or plane provided with an off angle from the (11-20) plane is used as the growth surface, but if applying this to the solution method, 3D growth undesirably occurs and flat growth cannot be obtained. Furthermore, with growth by the sublimation method among the conventional vapor phase growth methods, the practice has also been to use a surface inclined from the (0001) plane in the [11-20] direction by an off angle as the growth surface, but even if applying this to the solution method, flat growth cannot be obtained.

In the present invention, the optimum off angle is 4° to 12° from the viewpoint of securing flatness of the growth surface and promoting an enlargement of diameter.

FIG. 3 shows an example of the structure of an SiC single crystal production furnace suitable for working the method of the present invention.

The illustrated SiC single crystal production furnace 100 is a furnace maintaining a temperature gradient in the Si melt M in a graphite crucible 10 where the temperature falls from the inside to the melt surface S and grows an SiC single crystal starting from an SiC seed crystal 14 held by a graphite rod 12 directly under the melt surface S.

The entire graphite crucible 10 is wrapped around by an insulating material 18. The assembly is then housed all together in a quartz tube 20. An induction coil 22 is wound around the outer circumference of the quartz tube 20. A top stage coil 22A and bottom stage coil 22B forming the induction coil 22 can be controlled independently so that the necessary temperature gradient is formed in the Si melt M. The bottom temperature Tb of the crucible 10 and the temperature Ts of the melt surface S are measured by pyrometers. Based on the measured temperatures, the output of the induction coil 22 is adjusted to control the temperature of the Si melt and temperature gradient to predetermined values. When it is necessary to suppress the natural convection of the Si melt M, a magnetic field coil 24 is used to apply a magnetic field to the Si melt M.

The general process of production of an SiC single crystal using the SiC single crystal production furnace 100 proceeds as follows:

First, Si material is charged into the graphite crucible 10 and the induction coil 22 is actuated to form an Si melt M.

An SiC seed crystal is attached to a bottom end of the graphite rod 12 and inserted directly below the Si melt surface S.

The induction coil 22 is raised in output to raise the temperature of the melt M. At this time, the top stage coil 22A output/bottom stage coil 22B output is made to become 30 to 50% or so to raise the temperature while forming a temperature gradient in the Si melt where the temperature falls from the bottom to the top. From around when the temperature of the bottom of the melt exceeds the melting point of Si (1410°C), carbon (C) starts to gradually dissolve in the bottom high temperature Si melt from the graphite crucible 10.

The dissolved carbon (C) is transported upward in the Si melt due to diffusion and convection and reaches the SiC seed crystal 14. The vicinity of the seed crystal 14 is maintained at a lower temperature than the bottom of the melt due to the output control of the top stage/bottom stage of the coil 22 and the release of heat from the melt surface S. When the carbon (C) dissolved at the bottom of the high temperature, large solubility melt reaches the vicinity of the low temperature, low solubility seed crystal, the result becomes a supersaturated state. This supersaturation is used as the drive force for growing an SiC single crystal on the seed crystal.

### EXAMPLES

### [Example 1]

The SiC single crystal production furnace 100 of FIG. 3 was used and the off angle θ according to the present invention was applied to produce an SiC single crystal by the solution method.

In this example, an SiC seed crystal 14 with a growth surface inclined from the (0001) plane in the [1-100] direction by an off angle θ=4° was attached to the bottom end of a graphite rod 12, then inserted directly under the Si melt surface S to grow an SiC single crystal under the following growth conditions.

### <Growth Conditions>

The Si melt temperature was set so as to provide a melt surface temperature Ts of 1800°C. A temperature gradient of 20°C/cm was given so that the temperature fell from the bottom of the crucible to the melt surface S. The inside the crucible was made an Ar gas atmosphere and held at ordinary pressure. To stabilize the flat growth more, one type of additive element, Al, already proposed by the applicant in Japanese Patent Publication (A) No. 2005-82435, was added to the Si melt to make the melt composition Si-10 at% A1.

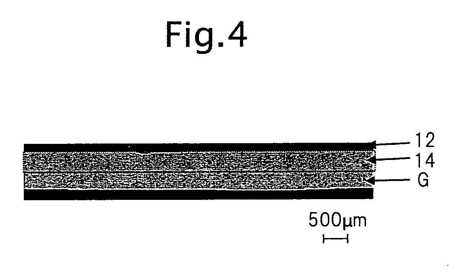

FIG. 4 shows a photo of the cross-section including the growth axis from the graphite rod 12 through the seed crystal 14 to the single crystal growth layer G. An SiC single crystal grew by an extremely high degree of flatness on the SiC seed crystal. Note that the ratio of enlargement of diameter with respect to the seed crystal was about 1.2 times.

### [Example 2]

An SiC seed crystal 14 with a growth surface made the (1-100) plane (that is, with an off angle θ=90° from the (0001) plane to the [1-100] direction) was attached to the bottom end of a graphite rod 12, then inserted directly under the Si melt surface S to grow an SiC single crystal under the same growth conditions as Example 1.

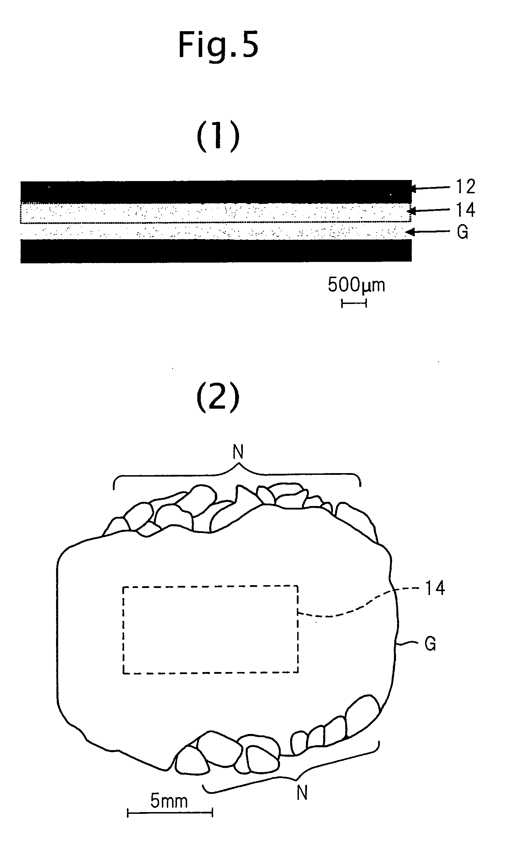

FIG. 5(1) shows a photo of the cross-section including the growth axis from the graphite rod 12 through the seed crystal 14 to the single crystal growth layer G. An SiC single crystal grew by an extremely high degree of flatness on the SiC seed crystal.

In this case, further, as shown by the sketch of the contours of the growth surface in FIG. 5(2), the SiC single crystal grown from the SiC seed crystal (contours shown by broken line rectangle) was increased in diameter by about two or more times. There were parts where the enlargement stopped due to polynucleated parts N occurring at part of the circumference, but these can be eliminated by considering the arrangement when first attaching the SiC seed crystal 14 to the graphite rod 12. Further, when further growing the crystal over this, it is confirmed that if removing the polynucleated parts N and then again growing the crystal, further enlargement of size occurs.

### [Comparative Example 1]

An SiC seed crystal 14 with a growth surface made the (0001) plane was attached to the bottom end of a graphite rod 12, then inserted directly under the Si melt surface S to grow an SiC single crystal under the same growth conditions as Example 1.

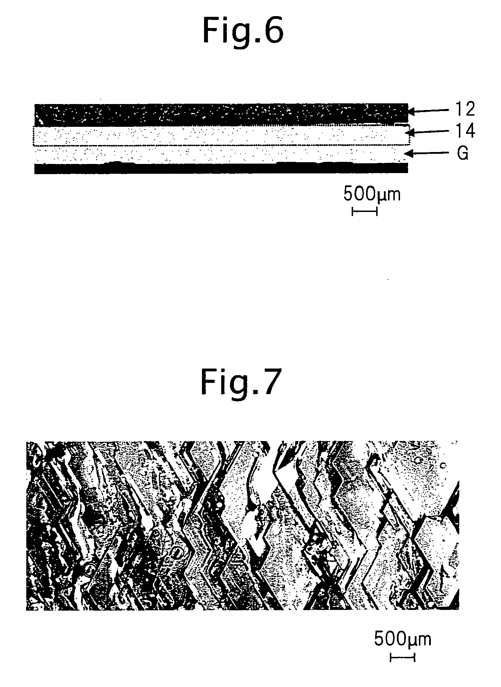

FIG. 6 shows a photo of the cross-section including the growth axis from the graphite rod 12 through the seed crystal 14 to the single crystal growth layer G. It will be understood that overall, flat growth is performed, but microsteps are formed and the mode of growth is affected sensitively by fluctuations in the growth conditions in the control range.

Note that the enlargement in diameter in this case was about 1.2 times the diameter of the seed crystal.

### [Comparative Example 2]

An SiC seed crystal with a growth surface inclined from the (0001) plane in the [11-20] direction by an off angle of 8° was attached to the bottom end of a graphite rod 12, then inserted directly under the Si melt surface S to grow an SiC single crystal under the same growth conditions as Example 1.

FIG. 7 shows a photo of a growth surface of an SiC single crystal. Growth proceeds separately in the off angle direction whereby overall a large number of steps are formed and flat growth is not obtained at all.

### [Comparative Example 3]

An SiC seed crystal 14 with a growth surface made the (11-20) plane (that is, with an off angle from the (0001) plane in the [11-20] direction of 90°) was attached to the bottom end of a graphite rod 12, then inserted directly under the Si melt surface S to grow an SiC single crystal under the same growth conditions as Example 1.

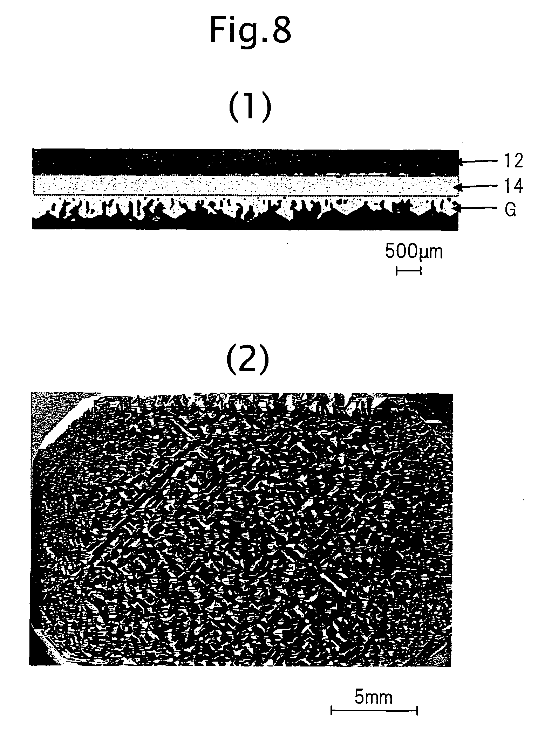

FIGS. 8 (1) and (2) show (1) a photo of the cross-section including the growth axis from the graphite rod 12 through the seed crystal 14 to the single crystal growth layer G and (2) a photo of the growth surface of the SiC single crystal. Overall, the result was a large number of fine separate island shaped growth surfaces. Flat growth could not be obtained at all.

### INDUSTRIAL APPLICABILITY

According to the present invention, a method of production of SiC single crystal using the solution method able to stably maintain flatness of a growth surface, prevent polycrystallization, and grow a large diameter SiC single crystal is provided.

## Claims

1. A method of growing a hexagonal SiC single crystal starting from a hexagonal SiC seed crystal held directly under a melt surface of an Si melt in a graphite crucible by maintaining in the Si melt a temperature gradient such that the temperature falls from the inside toward the melt surface of the Si melt, **characterized by**:
growing said SiC single crystal on a surface of said SiC seed crystal, which surface is inclined at a selected off angle from a (0001) plane of the SiC seed crystal in a [1-100] direction of the SiC seed crystal.

2. A method as set forth in claim 1, wherein said off angle is 1 to 30°.

3. A method as set forth in claim 1, growing said SiC single crystal on the (1-100) surface where said off angle is 90°.
